(19)

Europäisches Patentamt

European Patent Office

Office européen des brevets

(11) **EP 4 586 499 A1**

(12) **EUROPEAN PATENT APPLICATION**

published in accordance with Art. 153(4) EPC

(43) Date of publication:
**16.07.2025 Bulletin 2025/29**

(21) Application number: **23877421.0**

(22) Date of filing: **22.06.2023**

(51) International Patent Classification (IPC):
**H03F 1/02** (2006.01)          **H03F 3/21** (2006.01)
**H03F 1/56** (2006.01)

(52) Cooperative Patent Classification (CPC):
**H03F 1/02; H03F 1/56; H03F 3/21**

(86) International application number:
**PCT/KR2023/008701**

(87) International publication number:
**WO 2024/080490 (18.04.2024 Gazette 2024/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.10.2022 KR 20220130042
28.10.2022 KR 20220141910**

(71) Applicants:
• **Samsung Electronics Co., Ltd.
Suwon-si, Gyeonggi-do 16677 (KR)**
• **Research & Business Foundation
Sungkyunkwan University
Suwon-si, Gyeonggi-do 16419 (KR)**

(72) Inventors:
• **JEE, Seunghoon
Suwon-si Gyeonggi-do 16677 (KR)**
• **YANG, Youngoo
Suwon-si Gyeonggi-do 16419 (KR)**
• **KANG, Hyunuk
Suwon-si Gyeonggi-do 16677 (KR)**
• **KIM, Kyoungtae
Suwon-si Gyeonggi-do 16677 (KR)**
• **KIM, Changwook
Suwon-si Gyeonggi-do 16677 (KR)**
• **WOO, Youngyoon
Suwon-si Gyeonggi-do 16677 (KR)**
• **CHEN, Yifei
Suwon-si Gyeonggi-do 16419 (KR)**

(74) Representative: **Gulde & Partner
Patent- und Rechtsanwaltskanzlei mbB
Berliner Freiheit 2
10785 Berlin (DE)**

(54) **DOHERTY POWER AMPLIFIER AND ELECTRONIC DEVICE COMPRISING SAME**

(57)     A Doherty power amplifier of a wireless communication system is provided. The Doherty power amplifier may comprise: a first stage including a first power amplifier and a second power amplifier; a second stage including a third power amplifier and a fourth power amplifier; a coupler between the first stage and the second stage; and a load impedance connected to the second stage. The bias of the first power amplifier can be applied to be different from the bias of the second power amplifier. The bias of the third power amplifier can be applied to be the same as the bias of the fourth power amplifier.

FIG. 4

EP 4 586 499 A1

## Description

**[Technical Field]**

The disclosure relates to a wireless communication system, and for example, to a Doherty power amplifier and an electronic device including the same in a wireless communication system.

**[Background Art]**

In the 5G system, an electronic device may use a modulation method having a high peak to average power ratio (PAPR) in order to process a large amount of data capacity. In order to linearly amplify a modulation signal having the high PAPR, a power amplifier operates in a back-off region that is back-off by a certain value from the maximum output instead of a region having a maximum output. In this case, efficiency of the power amplifier operating in the back-off region is reduced and power consumption is increased. In order to improve amplifier efficiency in the back-off region, a Doherty power amplifier configured with two power amplifiers may be used. However, since the Doherty power amplifier has a limited back-off region in which efficiency is improved, efficiency improvement capability may be limited.

**[Disclosure]**

**[Technical Solution]**

According to various example embodiments, a Doherty power amplifier of a wireless communication system is provided. The Doherty power amplifier may comprise a first stage including a first power amplifier and a second power amplifier. The Doherty power amplifier may comprise a second stage including a third power amplifier and a fourth power amplifier. The Doherty power amplifier may comprise a coupler between the first stage and the second stage. The Doherty power amplifier may comprise a load impedance connected to the second stage. A bias of the first power amplifier may be applied differently from a bias of the second power amplifier. A bias of the third power amplifier may be applied in the same manner as a bias of the fourth power amplifier.

According to various example embodiments, an electronic device of a wireless communication system is provided. The electronic device may comprise at least one processor. The electronic device may comprise a plurality of radio frequency (RF) chains connected to the at least one processor. The electronic device may comprise a plurality of antenna elements connected to the plurality of RF chains. A RF chain among the plurality of RF chains may include a Doherty power amplifier. The Doherty power amplifier may comprise a first stage including a first power amplifier and a second power amplifier. The Doherty power amplifier may comprise a second stage including a third power amplifier and a fourth power amplifier. The Doherty power amplifier may comprise a coupler between the first stage and the second stage. The Doherty power amplifier may comprise a load impedance connected to the second stage. A bias of the first power amplifier may be applied differently from a bias of the second power amplifier. A bias of the third power amplifier may be applied in the same manner as a bias of the fourth power amplifier.

**[Description of the Drawings]**

The above and other aspects, features and advantages of certain embodiments of the present disclosure will be more apparent from the following detailed description, taken in conjunction with the accompanying drawings, in which:

FIG. 1 is a diagram illustrating an example wireless communication system according to various embodiments;
FIG. 2A is a diagram illustrating an example of a power amplifier according to various embodiments;
FIG. 2B is a diagram illustrating an example of a 2-stage Doherty power amplifier according to various embodiments;
FIG. 3A is a graph illustrating a phase difference between output currents of amplifiers of a main stage according to an input voltage according to various embodiments;
FIG. 3B is a graph illustrating output currents of amplifiers of a main stage according to an input voltage according to various embodiments;
FIG. 3C is a graph illustrating output voltages of amplifiers of a main stage according to an input voltage according to various embodiments;
FIG. 4 is a diagram illustrating an example of a 2-stage Doherty power amplifier according to various embodiments;
FIG. 5 is a diagram illustrating examples of a combiner according to various embodiments;
FIG. 6 is a diagram illustrating examples of a coupler according to various embodiments;
FIG. 7 is a diagram illustrating an example of a 2-stage Doherty power amplifier including a hybrid coupler according to various embodiments;

FIG. 8A is a graph illustrating a phase difference between output currents of amplifiers of a main stage according to an input voltage according to various embodiments;

FIG. 8B is a graph illustrating output current and output voltage of amplifiers of a main stage according to an input voltage according to various embodiments;

FIG. 8C is a graph illustrating a change in load impedance of a main amplifier of a main stage according to output power according to various embodiments;

FIG. 8D is a graph illustrating power efficiency of a 2-stage Doherty power amplifier according to output power according to various embodiments; and

FIG. 9 is a diagram illustrating an example configuration of an electronic device according to various embodiments.

With regard to the description of the drawings, the same or similar reference numerals may be used for the same or similar components.

**[Mode for Invention]**

Terms used in the present disclosure are used to describe various example embodiments and are not intended to limit the scope of any embodiment. A singular expression may include a plural expression unless it is clearly meant differently in context. The terms used herein, including a technical or scientific term, may have the same meaning as generally understood by a person having ordinary knowledge in the technical field described in the present disclosure. Terms defined in a general dictionary among the terms used in the present disclosure may be interpreted with the same or similar meaning as a contextual meaning of related technology, and unless clearly defined in the present disclosure, terms should not interpreted in an ideal or excessively formal meaning. In some cases, even terms defined in the present disclosure cannot be interpreted to exclude embodiments of the present disclosure.

In various embodiments of the present disclosure described below, a hardware approach is described as an example. However, since the various embodiments of the present disclosure include technology that use both hardware and software, the various embodiments of the present disclosure do not exclude a software-based approach.

A term referring to a component of the device (divider or splitter, power divider or power splitter, line, transmission line, feeding line, power amplifier, main stage, driver stage, Doherty power amplifier, carrier amplifier, main power amplifier, main amplifier, peaking amplifier, auxiliary power amplifier, auxiliary power amplifier, auxiliary amplifier, phase offset, modulation impedance, network, combiner, coupler, and the like), a term referring to a configuration of a component of a device (port, terminal, end, input end, output end, node), and the like used in the following description are illustrated for convenience of description. Therefore, the present disclosure is not limited to terms described below, and another term having an equivalent technical meaning may be used. In addition, a term such as '...part', '...er', '...material', '...body', and the like used below may refer to at least one shape structure, or may refer to a unit that processes a function.

In addition, in the present disclosure, in order to determine whether a specific condition is satisfied or fulfilled, an expression of more than or less than may be used, but this is only a description for expressing an example and does not exclude description of more than or equal to or less than or equal to. A condition described as 'more than or equal to' may be replaced with ' more than', a condition described as 'less than or equal to' may be replaced with 'less than', and a condition described as 'more than or equal to and less than' may be replaced with 'more than and less than or equal to'. In addition, hereinafter, 'A' to 'B' may refer to at least one of elements from A (including A) and to B (including B).

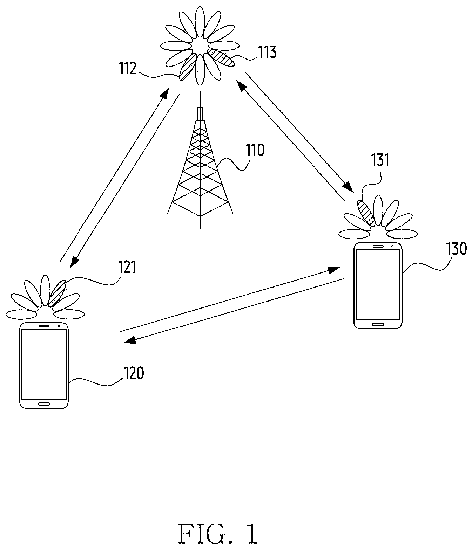

FIG. 1 is a diagram illustrating an example wireless communication system according to various embodiments. FIG. 1 illustrates a base station 110, a terminal 120, and a terminal 130 as a part of nodes that use a wireless channel in the wireless communication system. FIG. 1A illustrates one base station, but another base station the same as or similar to the base station 110 may be further included.

The base station 110 is a network infrastructure that provides wireless access to the terminals 120 and 130. The base station 110 has coverage defined as a certain geographic area based on a distance capable of transmitting a signal. The base station 110 may be referred to as an 'access point (AP)', an 'eNodeB (eNB)', a '5th generation node (5G node)', 'wireless point', 'transmission/reception point (TRP)' or another term having an equivalent technical meaning, in addition to the base station.

Each of the terminal 120 and the terminal 130 is a device used by a user and communicates with the base station 110 through the wireless channel. In some cases, at least one of the terminal 120 and the terminal 130 may be operated without user involvement. In other words, the at least one of the terminal 120 and the terminal 130 is a device that performs machine type communication (MTC) and may not be carried by the user. Each of the terminal 120 and the terminal 130 may be referred to as a 'user equipment (UE)', a 'mobile station', a 'subscriber station', 'customer premises equipment (CPE)', 'remote terminal', a 'wireless terminal', 'electronic device', or 'user device' or another term having an equivalent technical meaning, in addition to a terminal.

The base station 110, the terminal 120, and the terminal 130 may transmit and receive a wireless signal in a mmWave band (e.g., 28 GHz, 30 GHz, 38 GHz, 60 GHz, or 60 GHz or higher). At this time, in order to improve the channel gain, the base station 110, the terminal 120, and the terminal 130 may perform beamforming. Beamforming may include transmission beamforming and reception beamforming. In other words, the base station 110, the terminal 120, and the terminal 130 may assign directivity to a transmission signal or a reception signal. To this end, the base station 110 and the terminals 120 and 130 may select serving beams 112, 113, 121 and 131 through a beam search or beam management procedure. After the serving beams 112, 113, 121, and 131 are selected, subsequent communication may be performed through a resource having a quasi co-located (QCL) relationship with a resource that transmitted the serving beams 112, 113, 121, and 131.

The base station 110 or the terminals 120 and 130 may include an antenna array. Each antenna included in the antenna array may be referred to as an array element or an antenna element. The antenna array may be configured in various forms such as a 2-dimensional planar array, a linear array, or a multilayer array and the like. The antenna array may be referred to as a massive antenna array. In addition, the antenna array may include a plurality of sub arrays including a plurality of antenna elements.

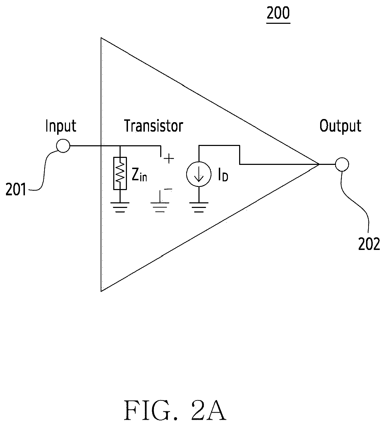

FIG. 2A is a diagram illustrating an example of a power amplifier for describing various embodiments.

FIG. 2A is an example of a power amplifier 200, which is simplified for convenience of description. The power amplifier 200 may amplify the power of the signal input through an input end 201 and export the amplified power to an output end 202. Hereinafter, assume that the power amplifier of the present disclosure is an amplifier matched with a voltage controlled current source (ID), and that the impedance of the input end 201 is Zin and is a real number. In other words, the current source ID connected to the output end may operate linearity according to the voltage of the input end 201. A bias of the power amplifier 200 is applied as the Class-C, and at a low power (LP) point, the power amplifier 200 may be in an off state.

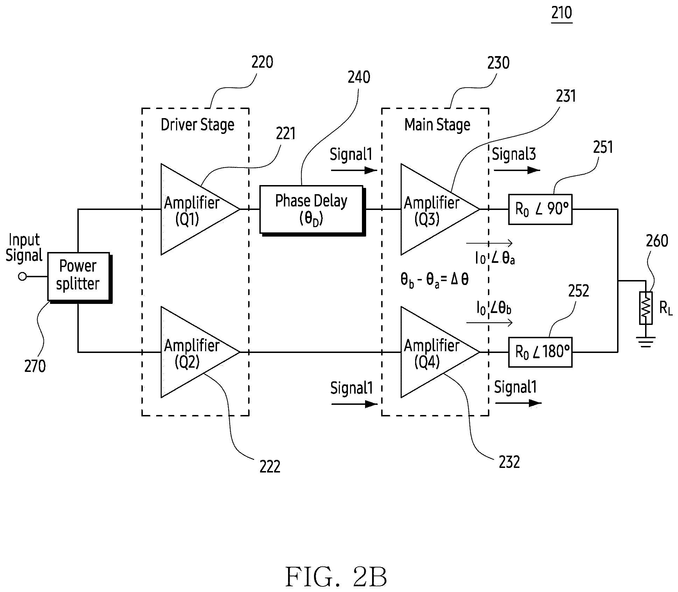

FIG. 2B is a diagram illustrating an example of a 2-stage Doherty power amplifier for describing a power amplifier for describing various embodiments. The Doherty power amplifier may be a power amplifier configured with two power amplifiers. Therefore, the 2-stage Doherty power amplifier is a Doherty power amplifier including two stages, and the stage for driving may be referred to as a driver stage and the stage for output may be referred to as a main stage.

Referring to FIG. 2B, the 2-stage Doherty power amplifier (DPA) 210 may include a driver stage 220, a main stage 230, a transmission line 240 for phase delay, a combiner 250 and a power splitter 270.

The driver stage 220 may include two power amplifiers. For example, the driver stage 220 may include a first power amplifier 221 and a second power amplifier 222. In this case, the first power amplifier 221 and the second power amplifier 222 may be amplifiers to which the same bias is applied. For example, the value of the bias current (or voltage) of the first power amplifier 221 may be the same as the value of the bias current (or voltage) of the second power amplifier 222. The bias of the first power amplifier 221 may be applied in the same manner as the bias of the second power amplifier 222. For example, the first power amplifier 221 may be an amplifier of a Class-AB bias, and the second power amplifier 222 may also be an amplifier of the Class-AB bias. This is merely an example, and the first power amplifier 221 and the second power amplifier 222 may be configured as amplifiers of Class-A, Class-B, and Class-C bias.

The main stage 230 may include two power amplifiers. For example, the main stage 230 may include a third power amplifier 231 and a fourth power amplifier 232. In this case, the third power amplifier 231 and the fourth power amplifier 232 may be amplifiers to which different biases are applied. For example, the value of the bias current (or voltage) of the third power amplifier 231 may be different from the value of the bias current (or voltage) of the fourth power amplifier 232. The bias of the third power amplifier 231 may be applied differently from the bias of the fourth power amplifier 232. For example, the third power amplifier 231 may be an amplifier of the Class-AB bias, and the fourth power amplifier 232 may be an amplifier of the Class-C bias. This is merely an example, and the third power amplifier 231 may be an amplifier of the Class-A or Class-B bias. The fourth power amplifier 232 may be configured with an amplifier of the Class-AB, Class-B, or Class-C bias. The third power amplifier 231 may be referred to as a carrier amplifier, a main power amplifier, and a main amplifier. The fourth power amplifier 232 may be referred to as a peaking amplifier, an auxiliary power amplifier, or an auxiliary amplifier.

The transmission line 240 may be connected between the driver stage 220 and the main stage 230. For example, the transmission line 240 may connect an output end of the first power amplifier 221 to an input end of the third power amplifier 231. The transmission line 240 may form a phase difference between signals applied to the main stage 230. In other words, the transmission line 240 may be a structure for forming a phase difference between a signal (signal1) input to the third power amplifier 231 which is the main amplifier and a signal (signal2) input to the fourth power amplifier 232 which is the peaking amplifier. Here, the phase difference by the transmission line 240 may be $\theta_D$.

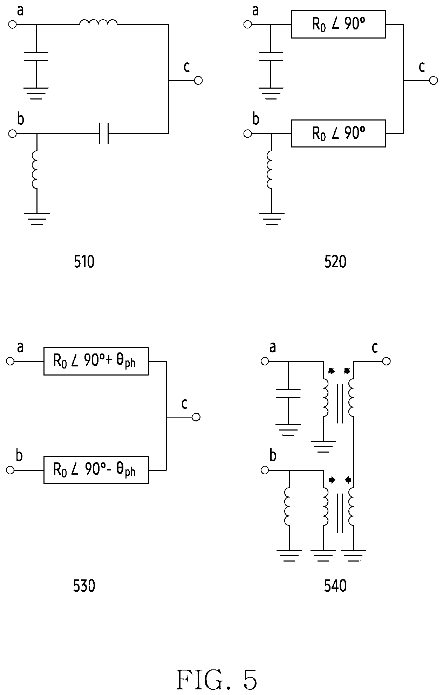

The combiner 250 is a structure for impedance modulation and may be connected to the third power amplifier 231, the fourth power amplifier 232, and a load impedance 260. The combiner 250 may include a first modulation structure 251 connected to the third power amplifier 231 and a second modulation structure 252 connected to the fourth power amplifier 232. For example, the first modulation structure 251 and the second modulation structure 252 may have a structure including at least one of a lumped element, a transmission line, or a transformer. Details of this are described in FIG. 5. For example, the first modulation structure 251 may be configured with the characteristic impedance of $R_0$ and an impedance having an electrical length of 90°, and the second modulation structure 252 may be configured with the

characteristic impedance of $R_0$ and an impedance having an electrical length of 180°. A signal (signal 3) passing through the first modulation structure 251 and a signal (signal 4) passing through the second modulation structure 252 may be combined and applied to the load impedance 260.

The power splitter 270 may distribute the input signal applied to the 2-stage Doherty power amplifier 210 and apply the signal to the power amplifiers of the driver stage 220.

Referring to FIG. 2B, the current of the signal 3 passing through the third power amplifier 231 may have a size of $I_o$ and a phase of $\theta_a$, and the current of the signal 4 passing through the fourth power amplifier 232 may have a size of $I_0$ and a phase of $\theta_b$. In this case, $\theta_b$-$\theta_a$ may be defined as $\Delta\theta$.

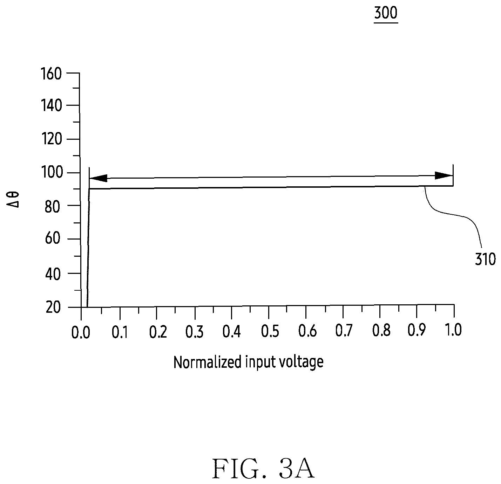

FIG. 3A is a graph illustrating a phase difference between output currents of amplifiers of a main stage according to an input voltage for describing various embodiments. Here, the main stage may refer, for example, to a main stage 230 of FIG. 2B, and the amplifiers of the main stage may be a third power amplifier 231 and a fourth power amplifier 232 of FIG. 2B. In addition, the phase difference $\Delta\theta$ may refer to the phase difference between the signal (signal 3 of FIG. 2B) output from the third power amplifier 231 and the signal (signal 4 of FIG. 2B) output from the fourth power amplifier 232.

A graph 300 of FIG. 3A illustrates a line 310 illustrating the phase difference $\Delta\theta$ according to the normalized input voltage. In the graph 300, the horizontal axis may refer to the magnitude of the normalized input voltage, and the vertical axis may refer to the phase difference (unit: °). Here, the normalized input voltage may be a voltage obtained by normalizing the magnitude of the input voltage of the 2-stage Doherty power amplifier to a value between 0 and 1. Referring to the line 310, even when the magnitude of the input voltage of the 2-stage Doherty power amplifier is changed, a phase difference between the signals (signal 1, signal 2) before being input to the power amplifiers (e.g., the third power amplifier 231 and the fourth power amplifier 232 of FIG. 2B) of the main stage or between the output signals (signal3, signal4) may be always maintained constant. In other words, even when the magnitude of the input voltage of the 2-stage Doherty power amplifier changes, the phase difference between signals input to the main stage of the 2-stage Doherty power amplifier may not change.

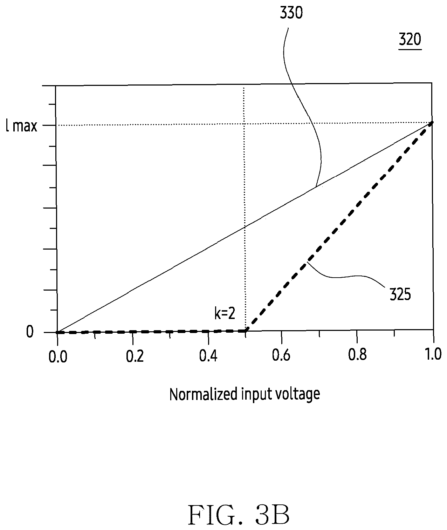

FIG. 3B is a graph illustrating output currents of amplifiers of a main stage according to an input voltage for describing various embodiments. Here, the main stage may refer, for example, to the main stage 230 of FIG. 2B, and the amplifiers of the main stage may be a third power amplifier 231 and a fourth power amplifier 232 of FIG. 2B.

A graph 320 of FIG. 3B illustrates a first line 325 illustrating the output current of an auxiliary amplifier of the main stage according to the normalized input voltage, and a second line 330 illustrating the output current of a main amplifier of the main stage according to the normalized input voltage. The horizontal axis of the graph 320 may refer to the magnitude of the normalized input voltage, and the vertical axis may refer to the current (unit: [A]). Here, the normalized input voltage may be a voltage obtained by normalizing the magnitude of the input voltage of the 2-stage Doherty power amplifier to a value between 0 and 1. The graph 320 illustrates a case where k is 2 for convenience of description as an example. Here, the k may refer, for example, to a modulation ratio of impedance, and here, the impedance may be the impedance when viewed from the output end of the main amplifier of the main stage in the direction of the load impedance. In addition, the modulation ratio may refer to the ratio between the impedance $R_{HP}$ in the state (high power, HP) where the output power of the power amplifier is high and the impedance $R_{LP}$ in the state where the output power is low. The modulation ratio may be defined as $R_{LP}/R_{HP}$. In this case, a threshold value for distinguishing a state in which the output power is high or low may be determined based on a power point at which the auxiliary amplifier is turned on. In the example of the graph 320, in case that the magnitude of the normalized input voltage is greater than 0.5, the auxiliary amplifier may be turned on. Therefore, the threshold value may be determined according to the output power of the power amplifier at 0.5 which is the magnitude of the input voltage.

Referring to the first line 325, when the magnitude of the input voltage of the 2-stage Doherty power amplifier is 0.5 or less, the auxiliary amplifier of the main stage may not output a current. In other words, the current of the auxiliary amplifier may be 0. However, in case that the magnitude of the input voltage exceeds 0.5, the auxiliary amplifier increases linearly until the magnitude of the current reaches the maximum value $I_{max}$. In this case, the slope of the first line 325 may be $2I_{max}$. On the other hand, referring to the second line 330, the current of the main amplifier of the main stage may increase linearly until it reaches the maximum value, regardless of the magnitude of the input voltage of the 2-stage Doherty power amplifier. In this case, the slope of the second line 330 may be $I_{max}$. According to the above, the ratio of the output current between the main amplifier and the auxiliary amplifier may vary depending on the input voltage (or the input voltage of the driver stage) of the 2-stage Doherty power amplifier.

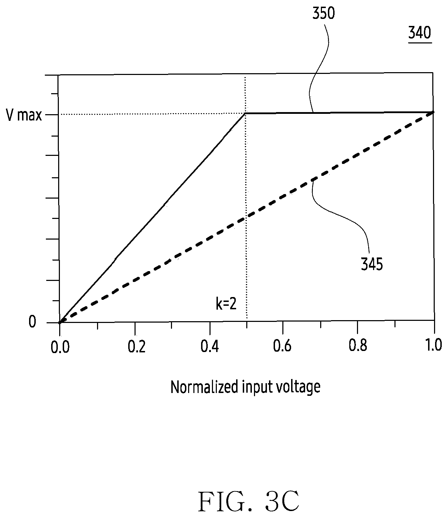

FIG. 3C is a graph illustrating output voltages of amplifiers of a main stage according to an input voltage for describing various embodiments. Here, the main stage means a main stage 230 of FIG. 2B, and the amplifiers of the main stage may be a third power amplifier 231 and a fourth power amplifier 232 of FIG. 2B.

A graph 340 of FIG. 3C illustrates a first line 345 illustrating the output voltage of the auxiliary amplifier of the main amplifier according to the normalized input voltage, and a second line 350 illustrating the output voltage of the main amplifier according to the normalized input voltage. The horizontal axis of the graph 340 may refer to the magnitude of the normalized input voltage, and the vertical axis may refer to the voltage (unit: [V]). Here, the normalized input voltage may be a voltage obtained by normalizing the magnitude of the input voltage of the 2-stage Doherty power amplifier to a value between 0 and 1. The graph 340 illustrates a case where k is 2 for convenience of description as an example. Here, the k may refer to the modulation ratio of the impedance, and here, the impedance may be the impedance when viewed from the output end of the main amplifier of the main stage in the direction of the load impedance. In addition, the modulation ratio may refer to the ratio between the impedance $R_{HP}$ in the state (high power, HP) where the output power of the power amplifier is high and the impedance $R_{LP}$ in the state where the output power is low. The modulation ratio may be $R_{LP}/R_{HP}$. In this case, a threshold value for distinguishing a state in which the output power is high or low may be determined based on a power point at which the auxiliary amplifier is turned on. In the example of a graph 320, in case that the magnitude of the normalized input voltage is greater than 0.5, the auxiliary amplifier may be turned on. Therefore, the threshold value may be determined according to the output power of the power amplifier at 0.5 which is the magnitude of the input voltage.

Referring to the first line 345, the voltage of the auxiliary amplifier of the main stage may linearly increase in proportion to the input voltage of the 2-stage Doherty power amplifier up to the maximum value $V_{max}$. In this case, the slope of the first line 345 may be $V_{max}$. On the other hand, referring to the second line 350, when the magnitude of the input voltage of the 2-stage Doherty power amplifier is 0.5 or less, the voltage of the main amplifier of the main stage may linearly increase until it reaches the maximum value. In this case, the slope of the second line 350 may be $2V_{max}$. In case that the magnitude of the input voltage of the 2-stage Doherty power amplifier exceeds 0.5, in other words, in case that the auxiliary amplifier is turned on, the output voltage of the main amplifier may be maintained at a maximum value.

Referring to FIGS. 2A, 2B, 3A, 3B and 3C, a wireless communication system may use a modulation method having a high PAPR in order to process a large amount of data. In this case, in order to linearly amplify a modulation signal having the high PAPR, the power amplifier may operate in a back-off region rather than a maximum output region. However, since efficiency of the back-off region may be reduced compared to the maximum output region, power consumption of the electronic device including the power amplifier may increase and battery usage may increase. In order to expand such a back-off region, the Doherty power amplifier may be used. In particular, the 2-stage Doherty power amplifier may include a driver stage configured with amplifiers of the two same bias and a main stage configured with amplifiers of two different bias. Since the power gain of the auxiliary amplifier at the main stage varies depending on the magnitude of the input power of the 2-stage Doherty power amplifier, and the magnitude ratio between the output current of the main amplifier and the auxiliary amplifier varies depending on the input power, load modulation may occur. In this case, the phase difference between the output current of the main amplifier and the auxiliary amplifier may be maintained constant, and the ratio to the magnitude of the amplitude in output signals of the main amplifier and the auxiliary amplifier may be changed. In other words, in the 2-stage Doherty power amplifier, only amplitude modulation may be generated. In addition, since the auxiliary amplifier uses a Class-C bias amplifier, the auxiliary amplifier is turned off at low output power, so there is a disadvantage that the gain of the main stage is reduced by half.

Therefore, hereinafter the present disclosure proposes the 2-stage Doherty power amplifier (hereinafter referred to as a phase modulation mode Doherty power amplifier) that is capable of phase modulation and improves power efficiency. The phase modulation mode Doherty power amplifier according to various embodiments of the present disclosure may include the amplifiers of the driver stage having different biases and the amplifiers of the main stage of the same bias. In addition, the phase modulation mode Doherty power amplifier according to an embodiment of the present disclosure may include a coupler between the driver stage and the main stage. In the phase modulation mode Doherty power amplifier according to an embodiment of the present disclosure, as the magnitude of the input power changes, the phase difference between the amplifiers of the main stage is changed and the ratio of the amplitude magnitude may be maintained constant. In other words, the phase modulation mode Doherty power amplifier according to the various embodiments of the present disclosure may perform phase modulation, and since all amplifiers of the main stage maintain an on state, the efficiency of the output power (or the gain of the power amplifiers of the main stage) may be improved. In addition, the electronic device including the phase modulation mode Doherty power amplifier according to an embodiment of the present disclosure may minimize and/or reduce power consumption and heat generation, and may extend the lifespan of a battery. The phase modulation mode Doherty power amplifier according to various embodiments of the present disclosure may be configured through minimal structural change compared to the existing structure, and may be used in a miniaturized design such as an integrated circuit.

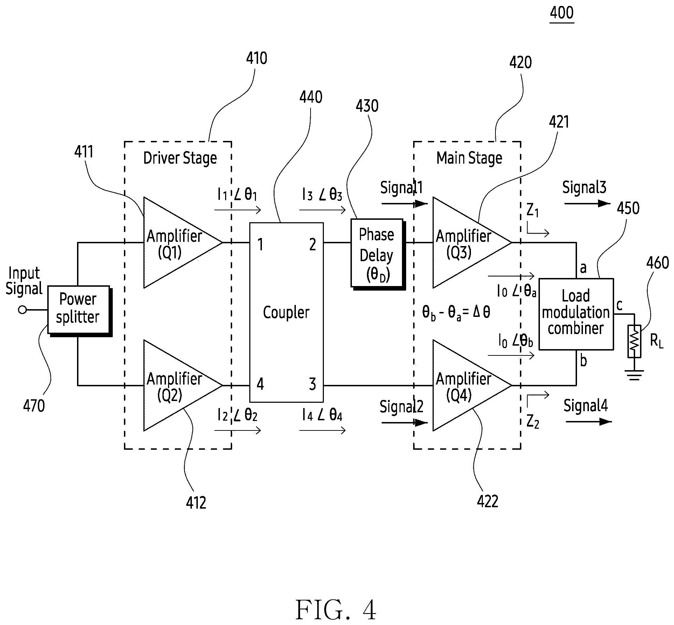

FIG. 4 is a diagram illustrating an example of a 2-stage Doherty power amplifier according to various embodiments. Here, the Doherty power amplifier may be a power amplifier configured with two power amplifiers. Therefore, the 2-stage Doherty power amplifier is a Doherty power amplifier including two stages, and the stage for driving may be referred to as a driver stage and the stage for output may be referred to as a main stage.

Referring to FIG. 4, the 2-stage Doherty power amplifier (DPA) 400 may include a driver stage 410, a main stage 420, a transmission line 430 for phase delay, a coupler 440, a combiner 450, and a power splitter 470. According to an embodiment, the 2-stage Doherty power amplifier 400 may be configured by being connected in the order of the power splitter 470 for distributing the input signal, the driver stage 410 receiving a signal from the power splitter 470, the coupler 440 for connecting the driver stage 410 and the main stage 420, the transmission line 430 connected to one output end of the coupler 440, the main stage 420 receiving a signal from the coupler 440, and the combiner 450 for combining the signals of the amplifiers of the main stage 420. A load impedance 460 $R_L$ may be connected to the output of the 2-stage Doherty power amplifier 400.

According to an embodiment, the driver stage 410 may include two power amplifiers. For example, the driver stage 410 may include a first power amplifier 411 and a second power amplifier 412. In this case, the first power amplifier 411 and the second power amplifier 412 may be amplifiers to which different biases are applied. For example, the value of the bias current (or voltage) of the first power amplifier 411 may be different from the value of the bias current (or voltage) of the second power amplifier 412. The bias of the first power amplifier 411 may be applied differently from the bias of the second power amplifier 412. For example, the first power amplifier 411 may be an amplifier of Class-A, Class-AB, or Class-B bias. The second power amplifier 412 may be an amplifier of the Class-AB, Class-B, or Class-C bias. In this case, in case that the first power amplifier 411 is an amplifier of the Class-AB bias, the second power amplifier 412 may be an amplifier of the Class-B or Class-C bias. Hereinafter, in the present disclosure, in case in which the first power amplifier 411 is the Class-AB bias amplifier and the second power amplifier 412 is the Class-C bias amplifier will be described as an example. However, the present disclosure is not limited thereto, and all cases that the first power amplifier 411 and the second power amplifier 412 have different biases, and the second power amplifier 412 is configured with a power amplifier that is a higher power efficiency bias than the first power amplifier 411, may be applied.

According to an embodiment, the main stage 420 may include two power amplifiers. For example, the main stage 420 may include a third power amplifier 421 and a fourth power amplifier 422. In this case, the third power amplifier 421 and the fourth power amplifier 422 may be amplifiers to which the same bias is applied. For example, the value of the bias current (or voltage) of the third power amplifier 421 may be the same as the value of the bias current (or voltage) of the fourth power amplifier 422. The bias of the third power amplifier 421 may be applied in the same manner as the bias of the fourth power amplifier 422. For example, the third power amplifier 421 and the fourth power amplifier 422 may be configured as an amplifier of the Class-A, Class-B, or Class-AB bias. The third power amplifier 421 may be referred to as a carrier amplifier, a main power amplifier, and a main amplifier. The fourth power amplifier 422 may be referred to as a peaking amplifier, an auxiliary power amplifier, and an auxiliary amplifier. In the example of FIG. 4, the current of a signal (signal 3) passing through the third power amplifier 421 may have a size of $I_0$ and a phase of $\theta_a$, and the current of a signal (signal 4) passing through the fourth power amplifier 422 may have a size of $I_0$ and a phase of $\theta_b$. In this case, $\theta_b - \theta_a$ may be defined as $\Delta\theta$.

According to an embodiment, the transmission line 430 may be connected between the driver stage 410 and the main stage 420. For example, the transmission line 430 may connect an output end of the first power amplifier 411 and an input end of the third power amplifier 421. In this case, the transmission line 430 may be connected to the output end of the first power amplifier 411 through the coupler 440. The transmission line 430 may form a phase difference between signals applied to the main stage 420. In other words, the transmission line 430 may have a structure for forming a phase difference between a signal (signal 1) input to the third power amplifier 421 which is the main amplifier and a signal (signal 2) input to the fourth power amplifier 422 which is the peaking amplifier. Here, the phase difference by the transmission line 430 may be $\theta_D$. The size of $\theta_D$ may be the same as that of $\Delta\theta(=\theta_b - \theta_a)$.

According to an embodiment, the coupler 440 may be disposed between the driver stage 410 and the main stage 420. For example, the coupler 440 may be connected to the first power amplifier 411 and the second power amplifier 412 of the driver stage 410. The coupler 440 may be connected to the third power amplifier 421 of the main stage 420 through the transmission line 430. The coupler 440 may be connected to the fourth power amplifier 422 of the main stage 420. According to an embodiment, the coupler 440 may be configured as a 4-port coupler. For example, the coupler 440 may be connected to the first power amplifier 411 through a first port, the transmission line 430 through a second port, the fourth power amplifier 422 through a third port, and the second power amplifier 412 through a fourth port. Here, the first port may be referred to as the input end. The first port may refer, for example, to a terminal connected to the output end of RF components such as the power amplifier. The second port may be referred to as a through end. The second port may refer, for example, to a terminal through which signals (e.g., RF signals) input from the output end of the RF components such as the power amplifier pass through the coupler 440 and are output. The third port may be referred to as a coupled end or other output end. The third port may refer, for example, to a terminal in which a part of a signal input to the first port is output using the coupler 440. The fourth port may be referred to as an isolated end. The fourth port may refer, for example, to a terminal that is not actually used for input/output but is used for stabilizing power. However, the location of each port of the coupler 440 may not be limited to the location of the ports of the coupler 440 illustrated in FIG. 4, but may be determined by the location of the port connected to the output end of other components (e.g., power amplifiers) connected to the coupler 440. In addition, in the present disclosure, a port may be referred to as a term having a similar or equivalent technical meaning, such as the terminal or the end and the like.

According to an embodiment, the combiner 450 has a structure for impedance modulation and may be connected to the third power amplifier 421, the fourth power amplifier 422, and the load impedance 460. The combiner 450 may include a port a connected to the third power amplifier 421, a port b connected to the fourth power amplifier 422, and a port c connected to the load impedance 460. For example, the combiner 450 may have a structure including at least one of a lumped element, a transmission line, or a transformer. Details of this are described in FIG. 5.

According to an embodiment, the power splitter 470 may distribute the input signal applied to the 2-stage Doherty power amplifier 400 to apply a signal to the power amplifiers 411 and 412 of the driver stage 410. Each of the input signals distributed through the power splitter 470 may be amplified and output through the first power amplifier 411 and amplified and output through the second power amplifier 412. The signals output from the first power amplifier 411 and the second power amplifier 412 may be transmitted to the main stage 420 through the coupler 440. The signals passing through the main stage 420 may be combined by the combiner 450 and transmitted to the load impedance 460.

Referring to the above, the signals input to the 2-stage Doherty power amplifier 400 are distributed through the power splitter 470, and may be input to the first power amplifier 411 and the second power amplifier 412, respectively. In case that the 2-stage Doherty power amplifier 400 is in the HP state, the first power amplifier 411 and the second power amplifier 412 may output a constant current, respectively. In case that the 2-stage Doherty power amplifier 400 is in the LP state, the second power amplifier 412 may be turned off. Therefore, as the magnitude of the input power changes, the ratio of the current $I_1\angle\theta_1$ output by the first power amplifier 411 to the current $I_2\angle\theta_2$ output by the second power amplifier 412 may vary. In this case, a ratio of the current of the first power amplifier 411 to the current of the second power amplifier 412 may be defined as in the following equation.

【 Equation 1 】

$$\beta = \frac{I_2\angle\theta_2}{I_1\angle\theta_1}$$

The $\beta$ refers to a ratio between the current of the first power amplifier 411 and the current of the second power amplifier 412, the $I_1$ refers to the magnitude of the current of the first power amplifier 411, the $I_2$ refers to the magnitude of the current of the second power amplifier 412, the $\theta_1$ refers to the phase of the current of the first power amplifier 411, and the $\theta_2$ refers to the phase of the current of the second power amplifier 412. According to an embodiment, since the phases of the current distributed through the power splitter 470 are the same, the $\beta$ may be a net real number. In other words, it may be calculated as $\beta = I_2/I_1$.

The signals amplified through the driver stage 410 may be transmitted to the main stage 420 through the coupler 440, respectively. In this case, the transmission line 430 may be connected between the coupler 440 and the third power amplifier 421 in order to form a phase difference between the signal (signal 1) input to the third power amplifier 421 of the main stage 420 and the signal (signal 2) input to the fourth power amplifier 422. The signal (signal 1) input to the third power amplifier 421 by the transmission line 430 may be delayed in phase by $\theta_D$ compared to the signal (signal 2) input to the fourth power amplifier 422. Thereafter, the signals (signal 1 and signal 2) input to the main stage 420 may be applied to the third power amplifier 421 and the fourth power amplifier 422, respectively, and may be amplified and output. The phase difference between the signal (signal 3) amplified and output by the third power amplifier 421 and the signal (signal 4) amplified and output by the fourth power amplifier 422 may be the same as the phase difference between the signal (signal 1) input to the third power amplifier 421 by the transmission line 430 and the signal (signal2) input to the fourth power amplifier 422. In other words, the phase difference between the signals before being input to the main stage 420 may be maintained even after being output from the main stage 420. For example, $\Delta\theta(=\theta_b-\theta_a)$, which is a phase difference between the current $I_0\angle\theta_a$ of the signal (signal 3) and the current $I_0 L\theta_b$ of the signal (signal 4), may be the same value as $\theta_D$. The relationship between $\Delta\theta$ and $\beta$, which is a ratio between input currents of the driver stage 410, is as shown in the following equation.

【 Equation 2 】

$$\tan(\Delta\theta) = \frac{1-\beta^2}{2\beta}$$

The $\beta$ refers to a ratio between the current of the first power amplifier 411 and the current of the second power amplifier 412, and the $\Delta\theta$ refers to a difference between the phase of the current of the signal (signal 3) output from the third power amplifier 421 and the phase of the current of the signal (signal 4) output from the fourth power amplifier 422. As described above, the phase difference of signals output from the main stage 420 may be changed according to the ratio of currents output from the driver stage 410. In the present disclosure, it is assumed that the phases of the signals distributed by the power splitter 470 are the same and the phases of the signals amplified by the driver stage 410 are also unchanged. Therefore, the phase difference of the signals output from the main stage 420 may be changed according to the magnitude ratio of the currents output from the driver stage 410. The signals amplified by the main stage 420 may be combined by the combiner 450, and the combined signal may be applied to the load impedance 460.

According to an embodiment, the load impedance $Z_1$ viewed from the output end of the third power amplifier 421 may be modulated based on the phase difference $\Delta\theta$ between the current $I_\theta\angle L\theta_a$ of the signal (signal 3) output by the third power amplifier 421 and the current $I_\theta\angle L\theta_b$ of the signal (signal 4) output by the fourth power amplifier 422. Here, the modulation ratio of the load impedance $Z_1$ may mean the ratio of the impedance viewed from the output end of the third power amplifier 421 in the HP state and the impedance viewed from the output end of the third power amplifier 421 in the LP state.

In summary, the ratio $\beta$ of currents output from the driver stage 410 may vary depending on the magnitude of the power of the input signal of the 2-stage Doherty power amplifier 400. In addition, the phase difference $\Delta\theta$ of the signals output from the main stage 420 may be changed according to the ratio $\beta$ of the output currents. The load impedance $Z_1$ viewed from the output end of the third power amplifier 421 may be modulated by the phase difference $\Delta\theta$ of the signals output from the main stage 420. In other words, depending on the magnitude of the power of the input signal of the 2-stage Doherty power amplifier 400, the load impedance $Z_1$ viewed from the output end of the third power amplifier 421 may be modulated. A specific equation expression related to this is as follow.

【 Equation 3 】

$$\beta = \tan(\Delta\theta) = \frac{k-1}{2\sqrt{k}}$$

The $\beta$ refers to a ratio between the current of the first power amplifier 411 and the current of the second power amplifier 412, the $\Delta\theta$ refers to a difference between the phase the current of the signal (signal 3) output from the third power amplifier 421 and the phase of the current of the signal (signal 4) output from the fourth power amplifier 422, and the k refers to the ratio $R_{LP}/R_{HP}$ of the impedance viewed from the output end of the third power amplifier 421 in the HP state by the 2-stage Doherty power amplifier 400 and the impedance viewed from the output end of the third power amplifier 421 in the LP state.

In addition, according to the transmission line theory, the range of the back-off region of the power amplifier may be changed according to the load impedance modulation ratio k of the main amplifier of the main stage. A specific equation expression related to this is as follow.

【 Equation 4 】

$$P_{backoff} = 20 \log k$$

The $P_{backoff}$ refers to the back-off power of the two-stage Doherty power amplifier, and the k refers to the ratio $R_{LP}/R_{HP}$ of the impedance viewed from the output end of the third power amplifier 421 in the HP state by the 2-stage Doherty power amplifier 400 and the impedance viewed from the output end of the third power amplifier 421 in the LP state.

As described above, by adjusting the power magnitude of the signal input to the 2-stage Doherty power amplifier, the modulation ratio of the impedance viewed from the main amplifier of the main stage may be changed. In addition, as the modulation ratio of the impedance changes, the back-off power (e.g., the back-off region) of the 2-stage Doherty power amplifier may change. Accordingly, a phase modulation mode Doherty power amplifier according to various embodiments of the present disclosure may change the back-off region by adjusting the input signal, and accordingly, the performance of the power amplifier may be improved. In addition, the electronic device including the phase modulation mode Doherty power amplifier according to an embodiment of the present disclosure may minimize and/or reduce power consumption and heat generation, and may extend the lifespan of a battery. The phase modulation mode Doherty power amplifier according to various embodiments of the present disclosure may be configured through minimal structural change compared to the existing structure, and may be used in a miniaturized design such as an integrated circuit.

FIG. 5 is a diagram illustrating examples of a combiner according to various embodiments.

Combiners 510, 520, 530, and 540 of FIG. 5 illustrate an example of a combiner 450 of FIG. 4. According to an embodiment, each of the combiners 510, 520, 530, and 540 may include at least one of a lumped element, a transmission line, or a transformer.

According to an embodiment, the combiner 510 may include the lumped elements. The combiner 510 may be configured with a capacitor connected to the ground at port a, an inductor between port a and port c, an inductor connected to the ground at port b, and a connection of a capacitor between port b and port c.

According to an embodiment, the combiner 520 may include the lumped elements and the transmission lines. The combiner 520 may be configured with a capacitor connected to the ground at port a, a transmission line between port a and port c, an inductor connected to the ground at port b, and a connection of a transmission line between port b and port c. In this case, a transmission line between port a and port c and a transmission line between port b and port c may be the same. For example, the transmission line may be formed to have a characteristic impedance of $R_0$ and an electrical length of 90°. This is only an example, and the present disclosure is not limited thereto.

According to an embodiment, a combiner 530 may include the transmission lines. The combiner 530 may be configured with connection of a transmission line between port a and port c and a transmission line between port b and port c. In this case, the transmission line between port a and port c and the transmission line between port b and port c may have the same characteristic impedance and different phases. For example, the transmission line between port a and port c and the transmission line between port b and port c may be formed with the same characteristic impedance $R_0$. However, the electrical length of the transmission line between port a and port c may be configured with $90°+\theta_{ph}$, and the electrical length of the transmission line between port b and port c may be configured with $90°-\theta_{ph}$. In this case, the phase between the transmission lines may be formed to lag or lead by the same value based on 90°. This is merely an example for convenience of explanation, and the present disclosure is not limited thereto. It may be formed to lag or lead by the same value based on a value other than 90°.

According to an embodiment, combiner 540 may include the lumped elements and the transformer. The combiner 540 may be configured with a capacitor connected to the ground at port a, an inductor connected to the ground at port b, and a connection of the transformer of between ports a, b, and c.

As described above, the combiner may be formed based on various electrical elements. In other words, in FIG. 5, examples of four combiners are illustrated, but an embodiment of the present disclosure is not limited thereto. An embodiment of the present disclosure may be applied to both circuits or structures having the same electrical function (combination of signals).

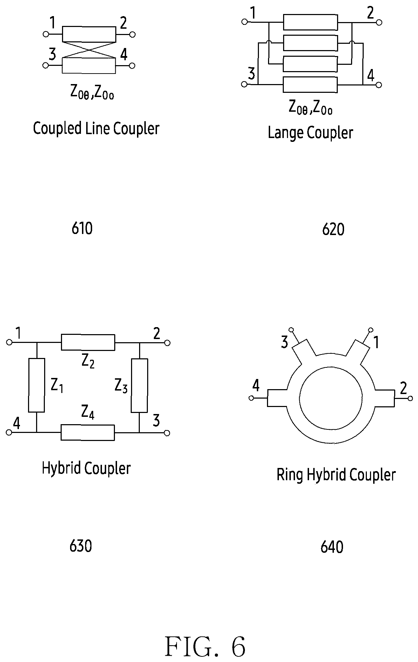

FIG. 6 is a diagram illustrating examples of a coupler according to various embodiments. FIG. 6 illustrates various couplers 610, 620, 630 and 640 for a coupler 440 of FIG. 4. However, a coupler of a phase modulation mode Doherty power amplifier according to various embodiments of the present disclosure will not be limited to the couplers illustrated in FIG. 6.

FIG. 6 illustrates a coupled line coupler 610, a lange coupler 620, a hybrid coupler 630, and ring hybrid coupler 640.

The coupled line coupler 610 may refer to a coupler in which two lines are disposed in an adjacent state. In this case, the coupling amount may be adjusted by the distance and length of the two lines disposed in the adjacent state. Each of the ports (first to fourth ports) of the coupled line coupler 610 may be understood in the same manner as each port of the coupler 440 of FIG. 4. In other words, a first port of the coupled line coupler 610 may refer to an input end, a second port may refer to a through end, a third port may refer to a coupled end or other output end, and a fourth port may refer to an isolated end.

The lange coupler 620 may refer to a coupler formed in a form in which lines are bent. Accordingly, the lange coupler 620 may be formed to have a relatively small size compared to other couplers. Each of the ports (first to fourth ports) of the lange coupler 620 may be understood in the same manner as each of the ports of the coupler 440 of FIG. 4. In other words, the first port of the lange coupler 620 may refer to the input end, the second port may refer to the through end, the third port may refer to the coupled end or other output end, and the fourth port may refer to the isolated end.

The hybrid coupler 630 may refer to a coupler that is directly coupled through branch lines (e.g., Z1 and Z3) connecting lines disposed in parallel. Accordingly, the hybrid coupler 630 may be referred to as a branch line coupler. Each of the ports (first to fourth ports) of the hybrid coupler 630 may be understood as the same as each of the ports of the coupler 440 of FIG. 4. In other words, the first port of the hybrid coupler 630 may refer to the input end, the second port may refer to the through end, the third port may refer to the coupled end or other output end, and the fourth port may refer to the isolated end.

The ring hybrid coupler 640 may refer to a coupler in which a circular line and four ports are disposed. Each of the ports (first to fourth ports) of the ring hybrid coupler 640 may be understood as the same as each of the ports of the coupler 440 of FIG. 4. In other words, the first port of the ring hybrid coupler 640 may refer to the input end, the second port may refer to the through end, the third port may refer to the coupled end or other output end, and the fourth port may refer to the isolated end.

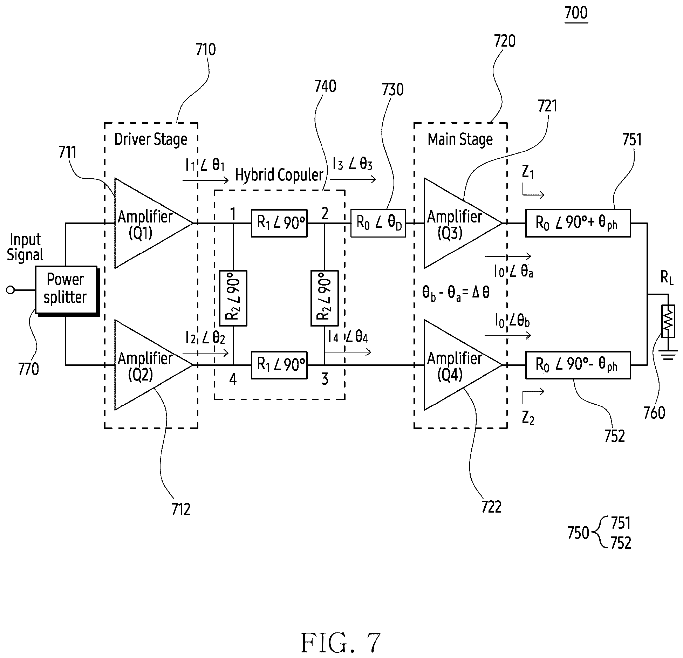

FIG. 7 is a diagram illustrating an example of a 2-stage Doherty power amplifier including a hybrid coupler according to various embodiments. Here, the Doherty power amplifier may be a power amplifier configured with two power amplifiers. Therefore, the 2-stage Doherty power amplifier is a Doherty power amplifier including two stages, and the stage for driving may be referred to as a driver stage and the stage for output may be referred to as a main stage.

Referring to FIG. 7, a 2-stage Doherty power amplifier 700, which is a specific example of the 2-stage Doherty power amplifier 400 of FIG. 4, is illustrated. For example, the 2-stage Doherty power amplifier 700 may include a hybrid coupler and a combiner including transmission lines.

Referring to FIG. 7, the 2-stage Doherty power amplifier (DPA) 700 may include a driver stage 710, a main stage 720, a transmission line 730 for phase delay, a coupler 740, a combiner 750, and a power splitter 770. According to an embodiment, the 2-stage Doherty power amplifier 700 may be configured by being connected in the order of the power splitter 770 for distributing the input signal, the driver stage 710 receiving a signal from the power splitter 770, the coupler 740 for connecting the driver stage 710 and the main stage 720, the transmission line 730 connected to one output end of the coupler 740, the main stage 720 receiving a signal from the coupler 740, and the combiner 750 for combining the signals of the amplifiers of the main stage 720. A load impedance 760 $R_L$ may be connected to the output of the 2-stage Doherty power amplifier 700.

According to an embodiment, the driver stage 710 may include two power amplifiers. For example, the driver stage 710 may include a first power amplifier 711 and a second power amplifier 712. In this case, the first power amplifier 711 and the second power amplifier 712 may be amplifiers to which different biases are applied. For example, the value of the bias current (or voltage) of the first power amplifier 711 may be different from the value of the bias current (or voltage) of the second power amplifier 712. The bias of the first power amplifier 711 may be applied differently from the bias of the second power amplifier 712. For example, the first power amplifier 711 may be an amplifier of Class-A, Class-AB, or Class-B bias. The second power amplifier 712 may be an amplifier of the Class-AB, Class-B, or Class-C bias. In this case, in case that the first power amplifier 711 is an amplifier of the Class-AB bias, the second power amplifier 712 may be an amplifier of the Class-B or Class-C bias. Hereinafter, in the present disclosure, in case in which the first power amplifier 711 is the Class-AB bias amplifier and the second power amplifier 712 is the Class-C bias amplifier will be described as an example. However, the present disclosure is not limited thereto, and all cases that the first power amplifier 711 and the second power amplifier 712 have different biases, and the second power amplifier 712 is configured with a power amplifier that is a lower power efficiency bias than the first power amplifier 711, may be applied.

According to an embodiment, the main stage 720 may include two power amplifiers. For example, the main stage 720 may include a third power amplifier 721 and a fourth power amplifier 722. In this case, the third power amplifier 721 and the fourth power amplifier 722 may be amplifiers to which the same bias is applied. For example, the value of the bias current (or voltage) of the third power amplifier 721 may be the same as the value of the bias current (or voltage) of the fourth power amplifier 722. The bias of the third power amplifier 721 may be applied in the same manner as the bias of the fourth power amplifier 722. For example, the third power amplifier 721 and the fourth power amplifier 722 may be configured as an amplifier of the Class-A, Class-B, or Class-AB bias. The third power amplifier 721 may be referred to as a carrier amplifier, a main power amplifier, and a main amplifier. The fourth power amplifier 722 may be referred to as a peaking amplifier, an auxiliary power amplifier, and an auxiliary amplifier. In the example of FIG. 4, the current of a signal (signal 3) passing through the third power amplifier 721 may have a size of $I_0$ and a phase of $\theta_a$, and the current of a signal (signal 4) passing through the fourth power amplifier 722 may have a size of $I_0$ and a phase of $\theta_b$. In this case, $\theta_b$-$\theta_a$ may be defined as $\Delta\theta$.

According to an embodiment, the transmission line 730 may be connected between the driver stage 710 and the main stage 720. For example, the transmission line 730 may connect an output end of the first power amplifier 711 and an input end of the third power amplifier 721. In this case, the transmission line 730 may be connected to the output end of the first power amplifier 711 through the coupler 740. The transmission line 730 may form a phase difference between signals applied to the main stage 720. In other words, the transmission line 730 may have a structure for forming a phase difference between a signal (signal 1) input to the third power amplifier 721 which is the main amplifier and a signal (signal 2) input to the fourth power amplifier 722 which is the peaking amplifier. For example, the transmission line 730 may be formed to have a characteristic impedance of $R_0$ and an electrical length of $\theta_D°$. In this case, the phase difference by the transmission line 730 may be $\theta_D$. The size of $\theta_D$ may be the same as that of $\Delta\theta(=\theta_b-\theta_a)$.

According to an embodiment, the coupler 740 may be configured as a 4-port coupler. For example, the coupler 740 may be a hybrid coupler. In other words, the coupler 740 may be understood as an example of the hybrid coupler 630 of FIG. 6. The coupler 740 may include an element in which electrical characteristics between the first port and the second port having a characteristic impedance of $R_1$ and an electrical length of 90°. The coupler 740 may include an element in which electrical characteristics between the second port and the third port having a characteristic impedance of $R_2$ and an electrical length of 90°. The coupler 740 may include an element in which electrical characteristics between the third port and the fourth port having a characteristic impedance of $R_1$ and an electrical length of 90°. The coupler 740 may include an element in which electrical characteristics between the fourth port and the first port having a characteristic impedance of $R_2$ and an electrical length of 90°. Here, the first port may be referred to as an input end. The first port may refer to a terminal connected to the output end of RF components such as the power amplifier. The second port may be referred to as a through end. The second port may refer to a terminal through which signals (e.g., RF signals) input from the output end of the RF components such as the power amplifier pass through the coupler 740 and are output. The third port may be referred to as a coupled end or other output end. The third port may refer to a terminal in which a part of a signal input to the first port is output using the coupler 740. The fourth port may be referred to as isolated end. The fourth port may refer to a terminal that is not actually used for input/output but is used for stabilizing power. However, the location of each port of the coupler 740 may not be limited to the location of the ports of the coupler 740 illustrated in FIG. 4, but may be determined by the location of the port connected to the output end of other components (e.g., power amplifiers) connected to the coupler 740. In addition, in the present disclosure, a port may be referred to as a term having a similar or equivalent technical meaning, such as the terminal or the end and the like.

According to an embodiment, the coupler 740 may be disposed between the driver stage 710 and the main stage 720. For example, the coupler 740 may be connected to the first power amplifier 711 and the second power amplifier 712 of the driver stage 710. The coupler 740 may be connected to the third power amplifier 721 of the main stage 720 through the transmission line 730. The coupler 740 may be connected to the fourth power amplifier 722 of the main stage 720. The coupler 740 may be connected to the first power amplifier 711 through the first port, the transmission line 730 through a second port, the fourth power amplifier 722 through the third port, and the second power amplifier 712 through a fourth port.

According to an embodiment, the combiner 750 has a structure for impedance modulation and may be connected to the third power amplifier 721, the fourth power amplifier 722, and the load impedance 760. The combiner 750 may include a port a connected to the third power amplifier 721, a port b connected to the fourth power amplifier 722, and a port c connected to the load impedance 760.

According to an embodiment, the combiner 750 may include a first transmission line 751 and a second transmission line 752. For example, the first transmission line 751 may be formed to have a characteristic impedance of $R_0$ and an electrical length of $90°+\theta_{ph}$. The second transmission line 752 may be formed to have a characteristic impedance of $R_0$ and an electrical length of $90°-\theta_{ph}$. The combiner 750 of FIG. 7 may be understood as an example of a combiner 530 of FIG. 5.

According to an embodiment, the power splitter 770 may distribute the input signal applied to the 2-stage Doherty power amplifier 700 to apply a signal to the power amplifiers 711 and 712 of the driver stage 710. Each of the input signals distributed through the power splitter 770 may be amplified and output through the first power amplifier 711 and amplified and output through the second power amplifier 712. The signals output from the first power amplifier 711 and the second power amplifier 712 may be transmitted to the main stage 720 through the coupler 740. The signals passing through the main stage 720 may be combined by the combiner 750 and transmitted to the load impedance 760.

As described above, by adjusting the power magnitude of the signal input to the 2-stage Doherty power amplifier, the modulation ratio of the impedance viewed from the main amplifier of the main stage may be changed. In addition, as the modulation ratio of the impedance changes, the back-off power (e.g., the back-off region) of the 2-stage Doherty power amplifier may change. Accordingly, a phase modulation mode Doherty power amplifier according to various embodiments of the present disclosure may change the back-off region by adjusting the input signal, and accordingly, the performance of the power amplifier may be improved. In addition, the electronic device including the phase modulation mode Doherty power amplifier according to an embodiment of the present disclosure may minimize and/or reduce power consumption and heat generation, and may extend the lifespan of a battery. The phase modulation mode Doherty power amplifier according to various embodiments of the present disclosure may be configured through minimal structural change compared to the existing structure, and may be used in a miniaturized design such as an integrated circuit.

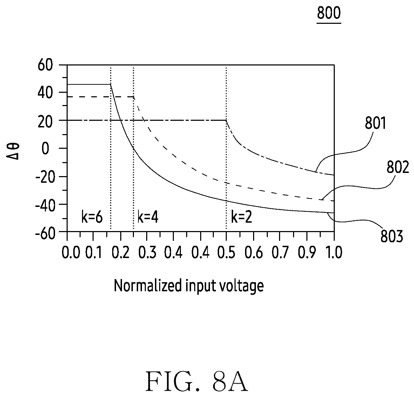

FIG. 8A is a graph illustrating a phase difference between output currents of amplifiers of a main stage according to an input voltage according to embodiments. Here, the main stage may refer to a main stage 420 of FIG. 4, and the amplifiers of the main stage may be a third power amplifier 421 and a fourth power amplifier 422 of FIG. 4. In addition, the phase difference $\Delta\theta$ may refer to the phase difference between the current for the signal (signal3 of FIG. 4) output from the third power amplifier 421 and the current for the signal (signal4 of FIG. 4) output from the fourth power amplifier 422.

A graph 800 of FIG. 8A illustrates a first line 801 illustrating the phase difference $\Delta\theta$ of the amplifiers of the main stage according to the normalized input voltage in case that k is 2, a second line 802 illustrating the phase difference of the amplifiers of the main stage according to the normalized input voltage in case that k is 4, and a third line 803 illustrating the phase difference of amplifiers of the main stage according to the normalized input voltage in case that k is 6. The horizontal axis of the graph 800 refers to the magnitude of the normalized input voltage, and the vertical axis refers to the phase difference (unit: °). Here, the normalized input voltage may be a voltage obtained by normalizing the magnitude of the input voltage of the 2-stage Doherty power amplifier to a value between 0 and 1. Here, the k may refer to the modulation ratio of the impedance, and here, the impedance may be the impedance when viewed from the output end of the main amplifier of the main stage in the direction of the load impedance. In addition, the modulation ratio may refer to the ratio between the impedance $R_{HP}$ in the state (high power, HP) where the output power of the power amplifier is high and the impedance $R_{LP}$ in the state where the output power is low. The modulation ratio may be defined as $R_{LP}/R_{HP}$. In this case, a threshold value for distinguishing a state in which the output power is high or low may be determined based on a power point at which the amplifier (e.g., a bias amplifier having high power efficiency of the driver stage, in case of FIG. 4, the second power amplifier 412) is turned on. In the example of the graph 800, in case of k=2, and when the magnitude of the normalized input voltage is 0.5, the amplifier may be turned on. In case of k=4, when the magnitude of the normalized input voltage is 0.25, the amplifier may be turned on. In case of k=6, when the magnitude of the normalized input voltage is about 0.16, the amplifier may be turned on.

Referring to the first line 801, even when the input voltage of the 2-stage Doherty power amplifier changes, the phase difference between the signals input to the main stage of the 2-stage Doherty power amplifier may not change until an amplifier of bias having a high power efficiency of the driver stage is turned on. However, when the input voltage of the 2-stage Doherty power amplifier changes after amplifier of bias having a high power efficiency of the driver stage is turned on, the phase difference between signals input to the main stage of the 2-stage Doherty power amplifier may vary. Considering the second line 802 and the third line 803, only the phase difference from the first line 801 and the magnitude of the input voltage on which the amplifier is turned on may vary, and the second line 802 and the third line 803 may be understood similarly to the first line 801. In other words, in the phase modulation mode Doherty power amplifier according to embodiments of the present disclosure, when the voltage (or power) magnitude of the input signal varies, the phase difference of the signals output from the amplifiers of the main stage may vary. In other words, as the impedance modulation ratio k of the main amplifier of the main stage varies, the phase difference of signals output from the amplifiers of the main stage may vary.

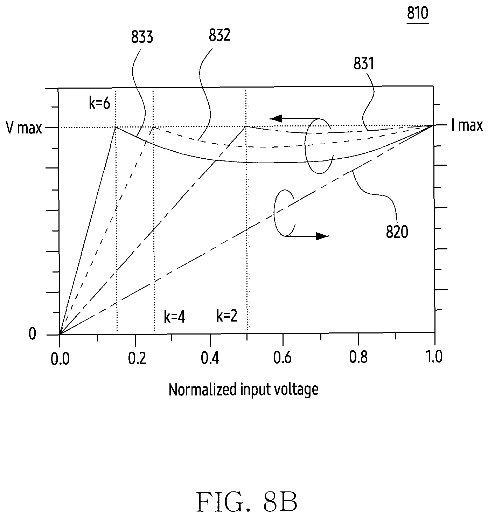

FIG. 8B is a graph illustrating output current and output voltage of amplifiers of a main stage according to an input voltage according to various embodiments. Here, the main stage refers to a main stage 420 of FIG. 4, and the amplifiers of the main stage may be a third power amplifier 421 and a fourth power amplifier 422 of FIG. 4. In addition, the phase difference $\Delta\theta$ may refer to the phase difference between the current for the signal (signal3 of FIG. 4) output from the third power amplifier 421 and the current for the signal (signal4 of FIG. 4) output from the fourth power amplifier 422.

A graph 810 of FIG. 8B illustrates a first line 831 illustrating the output voltage of the main amplifier (e.g., the third power amplifier 721 of FIG. 7) of the main stage according to the normalized input voltage in case that k is 2, a second line 832 illustrating the output voltage of the main amplifier of the main stage according to the normalized input voltage in case that k is 4, a third line 833 illustrating the output voltage of the main amplifier of the main stage according to the normalized input voltage in case that k is 6, and a fourth line 820 illustrating the output current of the main amplifier of the main stage according to the normalized input voltage in case that k is 2, 4, and 6. The horizontal axis of the graph 800 refers to the magnitude of the normalized input voltage, and the vertical axis refers to the voltage (unit: [V]) for the first line 831, the second line 832, and the third line 833, and the current (unit: [A]) for the fourth line 820. Here, the normalized input voltage may be a voltage obtained by normalizing the magnitude of the input voltage of the 2-stage Doherty power amplifier to a value between 0 and 1. Here, the k may refer to the modulation ratio of the impedance, and here, the impedance may be the impedance when viewed from the output end of the main amplifier of the main stage in the direction of the load impedance. In addition, the modulation ratio may refer to the ratio between the impedance $R_{HP}$ in the state (high power, HP) where the output power of the power amplifier is high and the impedance $R_{LP}$ in the state where the output power is low. The modulation ratio may be referred to as $R_{LP}/R_{HP}$. In this case, a threshold value for distinguishing a state in which the output power is high or low may be determined based on a power point at which the amplifier (e.g., a bias amplifier having high power efficiency of the driver stage, in case of FIG. 4, the second power amplifier 412) is turned on. In the example of the graph 810, in case of k=2, and when the magnitude of the normalized input voltage is 0.5, the amplifier may be turned on. In case of k=4, when the magnitude of the normalized input voltage is 0.25, the amplifier may be turned on. In case of k=6, when the magnitude of the normalized input voltage is about 0.16, the amplifier may be turned on.

Referring to the fourth line 820, regardless of the load impedance modulation ratio k, the output current of the 2-stage Doherty power amplifier may linearly increase in case that the magnitude of the normalized input voltage increases. For example, in case of k=2, 4, or 6, in case that the normalized input voltage is 0, the magnitude of the current may be 0, and in case that the normalized input voltage is maximum (1), the magnitude of the current may be maximum (I-max). In case of the output current, the slope of the output current according to the input voltage may be constant regardless of the load impedance modulation ratio.

On the other hand, in case that the load impedance modulation ratio is changed, the output voltage of the 2-stage Doherty power amplifier according to the input voltage may be changed. Here, the output voltage may refer to the output voltage of the main amplifier of the main stage. Referring to the first line 831, the output voltage of the 2-stage Doherty power amplifier may be the maximum value ($V_{max}$) when the magnitude of the input voltage is maximum (1). In addition, when the magnitude of the input voltage is 0.5, the output voltage may be a maximum value. In other words, in case of the first line 831, the back-off region of the 2-stage Doherty power amplifier may range from 0.5 to 1.0 based on the magnitude of the normalized input voltage. Referring to the second line 832, like the first line 831, the output voltage of the 2-stage Doherty power amplifier may be the maximum value ($V_{max}$) when the magnitude of the input voltage is maximum (1). However, unlike the first line 831, when the magnitude of the input voltage is 0.25, the output voltage may be the maximum value. In other words, in case of the second line 832, the back-off region of the 2-stage Doherty power amplifier may range from 0.25 to 1.0 based on the magnitude of the normalized input voltage, and may have a wider back-off region than that of the first line 831. In addition, referring to the third line 833, the output voltage of the 2-stage Doherty power amplifier, like the first line 831, may be the maximum value ($V_{max}$) when the magnitude of the input voltage is the maximum (1). However, unlike the first line 831, when the magnitude of the input voltage is about 0.16, the output voltage may be the maximum value. In other words, in case of the third line 833, the back-off region of the 2-stage Doherty power amplifier may be in the range of about 0.16 to 1.0 based on the magnitude of the normalized input voltage, and may have a wider back-off region than that of the first line 831 and the second line 832.

As described above, in case that the modulation ratio of the load impedance is changed, the output voltage of the phase modulation mode Doherty power amplifier according to an embodiment of the present disclosure may vary depending on the magnitude of an input voltage. In addition, since the output voltage is changed, the back-off region of the phase modulation mode Doherty power amplifier according to various embodiments of the present disclosure may be changed.

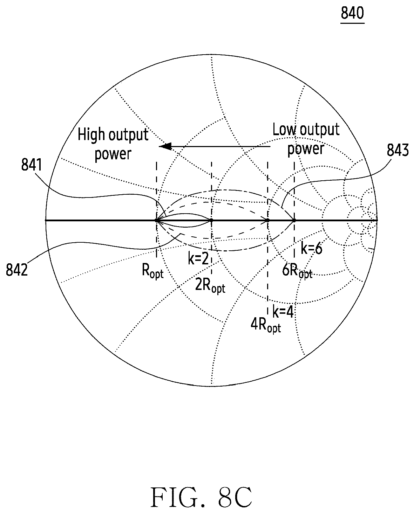

FIG. 8C is a graph illustrating a change in load impedance of a main amplifier of a main stage according to output power according to various embodiments. Here, the main stage refers to a main stage 420 of FIG. 4, and the amplifiers of the main stage may be a third power amplifier 421 and a fourth power amplifier 422 of FIG. 4. In addition, the phase difference $\Delta\theta$ may refer to the phase difference between the current for the signal (signal3 of FIG. 4) output from the third power amplifier 421 and the current for the signal (signal4 of FIG. 4) output from the fourth power amplifier 422.

A graph 840 illustrates the load impedance at the output stage of the main amplifier of the main stage according to the output power in the phase modulation mode Doherty power amplifier according to various embodiments of the present disclosure. The graph 840 illustrates a first line 841 illustrating a change in load impedance according to output power in case that the modulation ratio k of the load impedance is 2, a second line 842 illustrating a change in load impedance according to output power in case that k is 4, and a third line 843 illustrating a change in load impedance according to output power in case that k is 6. Here, $R_{opt}$ is the optimal load impedance viewed from the output end the main amplifier of the main stage when the phase modulation mode Doherty power amplifier according to various embodiments of the present disclosure has maximum output power.

Referring to the first line 841, when the output magnitude of the phase modulation mode Doherty power amplifier is changed from low output power to high output power, the magnitude of the load impedance may be changed from 2Ropt to Ropt. Referring to the second line 842, when the output magnitude of the phase modulation mode Doherty power amplifier is changed from low output power to high output power, the magnitude of the load impedance may be changed from 4Ropt to Ropt. Referring to the third line 843, when the output magnitude of the phase modulation mode Doherty power amplifier is changed from low output power to high output power, the magnitude of the load impedance may be changed from 6Ropt to Ropt. As described above, in the phase modulation mode Doherty power amplifier according to various embodiments of the present disclosure, as the output power increases, the magnitude of the load impedance viewed from the output end of the main amplifier of the main stage may be reduced to $R_{opt}$. In addition, regardless of the load impedance modulation ratio, the phase modulation mode Doherty power amplifier according to various embodiments of the present disclosure may have a load impedance of $R_{opt}$ in case that the output power is maximum. However, in the phase modulation mode Doherty power amplifier according to an embodiment of the present disclosure, when the output power is reduced, the magnitude of the load impedance viewed from the output end of the main amplifier of the main stage may increase to $kR_{opt}$.

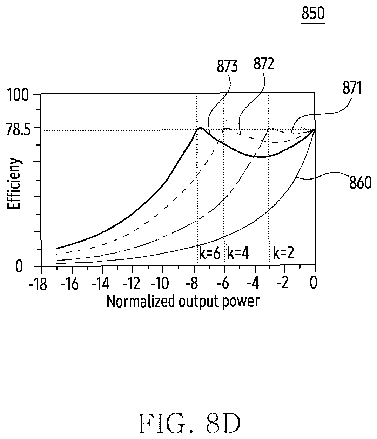

FIG. 8D is a graph illustrating power efficiency of a 2-stage Doherty power amplifier according to output power according to various embodiments. Here, the 2-stage Doherty power amplifier may refer to a phase modulation mode Doherty power amplifier according to an embodiment of the present disclosure. In FIG. 8D, for convenience of description, it is assumed that the main amplifier of the main stage is a Class-B bias amplifier.

The graph 850 illustrates a first line 871 illustrating the PAE according to the output power when the load impedance modulation ratio (k) of the phase modulation mode Doherty power amplifier is 2, a second line 872 illustrating a PAE according to output power when k of the phase modulation mode Doherty power amplifier is 4, a third line 873 illustrating a PAE according to output power when k of the phase modulation mode Doherty power amplifier is 6, and a fourth line 860 illustrates the power added efficiency (PAE) according to the output power of the power amplifier of the general Class-AB bias. The horizontal axis of the graph 850 may refer to the magnitude (unit: dB) of normalized output power, and the vertical axis may refer to power added efficiency (PAE) (unit: %).

Referring to the first line 871, in case that the output power is the maximum value (0), the PAE of the phase modulation mode Doherty power amplifier may be the maximum efficiency (78.5%). In addition, in case that the output power is about -3dB, the PAE of the phase modulation mode Doherty power amplifier may be the maximum efficiency (78.5%). In this case, the part where the output power is about -3 dB may refer to a low output power point compared to the maximum output power, and the power point where the amplifier with low power efficiency of the driver stage (e.g., a first power amplifier 411 of FIG. 4) is turned on. Referring to the second line 872, in case that the output power is the maximum value (0), the PAE of the phase modulation mode Doherty power amplifier may be the maximum efficiency (78.5%). In addition, in case that the output power is about -6dB, the PAE of the phase modulation mode Doherty power amplifier may be the maximum efficiency (78.5%). In this case, the part where the output power is about - 6 dB may refer to the low output power point compared to the maximum output power, and the power point where the amplifier with low power efficiency of the driver stage (e.g., the first power amplifier 411 of FIG. 4) is turned on. Referring to the third line 873, in case that the output power is the maximum value (0), the PAE of the phase modulation mode Doherty power amplifier may be the maximum efficiency (78.5%). In addition, in case that the output power is about -8dB, the PAE of the phase modulation mode Doherty power amplifier may be the maximum efficiency (78.5%). In this case, the part where the output power is about -8 dB may refer to the low output power point compared to the maximum output power, and the power point where the amplifier with low power efficiency of the driver stage (e.g., the first power amplifier 411 of FIG. 4) is turned on. Comparing the first line 871 to the third line 873, the power point (e.g., the low output power point) at which the amplifier (e.g., the first power amplifier 411 of FIG. 4) with low power efficiency of the driver stage is turned on may vary as the load impedance modulation ratio k varies. In other words, as the k value varies, the back-off region of the phase modulation mode Doherty power amplifier may vary. In case that the k value increases, the back-off region may be expanded.

Referring to the fourth line 860 illustrating the efficiency of a power amplifier of a general class-AB bias, in case that the output power is the maximum value (0), the PAE of the phase modulation mode Doherty power amplifier may be the maximum efficiency (78.5%). However, as the output power decreases, the PAE may decrease. Therefore, a general class-AB power amplifier may have a narrow back-off region.

As described above, in case of the phase modulation mode Doherty power amplifier according to various embodiments of the present disclosure, the back-off region may be expanded as the modulation rate of the load impedance of the main amplifier of the main stage is adjusted. Accordingly, the performance of the phase modulation mode Doherty power amplifier of the present disclosure may be improved since the high-efficiency back-off region is expanded compared to the general power amplifier.

Referring to FIGS. 1 to 8D, the phase modulation mode Doherty power amplifier according to an embodiment of the present disclosure may include amplifiers of a driver stage having different biases and amplifiers of a main stage of the same bias. In addition, the phase modulation mode Doherty power amplifier according to an embodiment of the present disclosure may include a coupler between the driver stage and the main stage. Compared to the general power amplifier, the phase modulation mode Doherty power amplifier having the structure described above has an expanded high-efficiency back-off region, and thus the performance of the power amplifier may be improved. In addition, the phase modulation mode Doherty power amplifier may minimize and/or reduce power consumption and heat generation, and may extend the lifespan of a battery. The phase modulation mode Doherty power amplifier may be configured through minimal structural changes compared to the existing structure, and may be used in miniaturized designs such as integrated circuits.

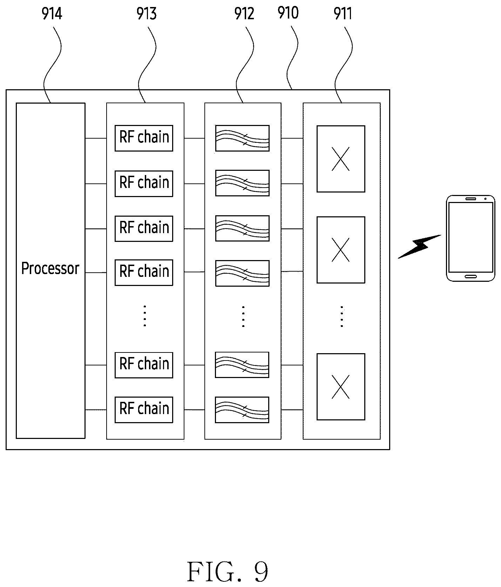

FIG. 9 is a diagram illustrating an example configuration of an electronic device according to various embodiments. An electronic device 910 may be one of a base station or a terminal. According to an embodiment, the electronic device 910 may be an MMU or a mmWave device. Not only a phase modulation mode Doherty power amplifier itself mentioned through FIGS. 1 to 8D, but also the structure of a radio frequency (RF) chain including the same and an electronic device including the same are also included in embodiments of the present disclosure.

Referring to FIG. 9, an example configuration of the electronic device 910 is illustrated. The electronic device 910 may include an antenna unit (e.g., including at least one antenna) 911, a filter unit (e.g., including a filter) 912, a radio frequency (RF) processing unit (e.g., including RF processing circuitry) 913, and a control unit (e.g., including processing/control circuitry) 914.

The antenna unit 911 may include a plurality of antennas. The antenna performs functions for transmitting and receiving signals through a wireless channel. The antenna may include a conductor formed on a substrate (e.g., an antenna PCB, an antenna board) or a radiator formed of a conductive pattern. The antenna may radiate the up-converted signal on the wireless channel or may obtain a signal radiated by another device. Each antenna may be referred to as an antenna element. In various embodiments, the antenna unit 911 may include an antenna array (e.g., a sub array) in which a plurality of antenna elements form an array. The antenna unit 911 may be electrically connected to the filter unit 912 through RF signal lines. The antenna unit 911 may be mounted on a PCB including the plurality of antenna elements. The PCB may include a plurality of RF signal lines connecting each antenna element and a filter of the filter unit 912. These RF signal lines may be referred to as a feeding network. The antenna unit 911 may provide the received signal to the filter unit 912 or may radiate the signal provided from the filter unit 912 into the air.

The antenna unit 911 according to various embodiments may include at least one antenna module having a dual polarization antenna. The dual polarization antenna may be, for example, a cross-pole (x-pole) antenna. The dual polarization antenna may include two antenna elements corresponding to different polarizations. For example, the dual polarization antenna may include a first antenna element having a polarization of +45° and a second antenna element having a polarization of -45°. It goes without saying that the polarization may be formed of other orthogonal polarizations other than +45° and -45°. Each antenna element may be connected to a feeding line and electrically connected to the filter unit 912, the RF processing unit 913, and the control unit 914 to be described later.

The dual polarization antenna may be a patch antenna (or a microstrip antenna). The dual polarization antenna may be easily implemented and integrated into an array antenna by having the form of the patch antenna. Two signals having different polarizations may be input to each antenna port. Each antenna port corresponds to the antenna element. For high efficiency, it is required to optimize the relationship between a co-pol characteristic and a cross-pol characteristic between two signals with different polarizations. In a dual polarization antenna, the co-pol characteristic represents a characteristic for a specific polarization component, and the cross-pol characteristic represents a characteristic for a polarization component different from the specific polarization component.

The filter unit 912 may include a filter and perform filtering in order to transmit a signal of a desired frequency. The filter unit 912 may perform a function of selectively identifying the frequency by forming a resonance. In various embodiments, the filter unit 912 may form the resonance through a cavity structurally including a dielectric. In addition, in various embodiments, the filter unit 912 may form the resonance through elements forming inductance or capacitance. In addition, in various embodiments, the filter unit 912 may include an elastic filter such as a bulk acoustic wave (BAW) filter or a surface acoustic wave (SAW) filter. The filter unit 912 may include at least one of a band pass filter, a low pass filter, a high pass filter, and a band reject filter. In other words, the filter unit 912 may include RF circuits for obtaining a signal of a frequency band for transmission or a frequency band for reception. The filter unit 912 according to various embodiments may electrically connect the antenna unit 911 and the RF processing unit 913.

The RF processing unit 913 may include various circuitry and a plurality of RF paths. The RF path may be a unit of a path through which a signal received through an antenna or a signal radiated through an antenna passes. At least one RF path may be referred to as an RF chain. The RF chain may include a plurality of RF elements. The RF elements may include an amplifier, a mixer, an oscillator, a DAC, an ADC, and the like. For example, the RF processing unit 913 may include an up converter that up-converts a base band digital transmission signal to a transmission frequency, and a digital-to-analog converter (DAC) that converts the up-converted digital transmission signal into an analog RF transmission signal. The up converter and the DAC form part of a transmission path. The transmission path may further include a power amplifier (PA) or a coupler (or combiner). In addition, for example, the RF processing unit 913 may include an analog-to-digital converter (ADC) that converts an analog RF reception signal into a digital reception signal and a down converter that converts a digital reception signal into a baseband digital reception signal. The ADC and the down converter form part of a reception path. The reception path may further include a low-noise amplifier (LNA) or a coupler (or a divider). RF components of the RF processing unit may be implemented on the PCB. The electronic device 910 may include a structure stacked in the order of the antenna unit 911 - the filter unit 912 - and the RF processing unit 913. The antennas and the RF components of the RF processing unit may be implemented on the PCB, and filters may be repeatedly fastened between the PCB and the PCB to form a plurality of layers. The phase modulation mode Doherty power amplifier according to embodiments of the present disclosure may be included in the RF processing unit 913.

The control unit 914 may include various processing/control circuitry and control overall operations of the electronic device 910. The control unit 914 may include various modules for performing communication. The control unit 914 may include at least one processor such as a modem. The control unit 914 may include modules for digital signal processing. For example, the control unit 914 may include a modem. When transmitting data, the control unit 914 generates complex symbols by encoding and modulating the transmission bit string. In addition, for example, when receiving data, the control unit 914 restores the reception bit string by demodulating and decoding the baseband signal. The control unit 914 may perform functions of a protocol stack required by a communication standard.

In FIG. 9, a functional configuration of an electronic device 910 is described as a device to which the Doherty power amplifier of the present disclosure may be utilized. However, the example illustrated in FIG. 9 is merely an example configuration for utilization of a structure including a power amplifier according to an embodiment of the present disclosure described through FIGS. 1 to 8D and an electronic device including the same, and various embodiments of the present disclosure are not limited to the components of the equipment illustrated in FIG. 9. Therefore, a configuration of a communication equipment including a phase modulation mode Doherty power amplifier structure according to an embodiment of the present disclosure and a communication equipment including the same may also be understood as an embodiment of the present disclosure.

As described above, a Doherty power amplifier (400) in wireless communication system according to various example embodiments, comprises a first stage (410) including a first power amplifier (411) and a second power amplifier (412). The Doherty power amplifier (400) comprises a second stage (420) including a third power amplifier (421) and a fourth power amplifier (422). The Doherty power amplifier (400) comprises a coupler (440) between the first stage (410) and the second stage (420). The Doherty power amplifier (400) comprises a load impedance (460) connected to the second stage (420). A bias of the first power amplifier (411) is different from a bias of the second power amplifier (412). A bias of the third power amplifier (421) corresponds to a bias of the fourth power amplifier (422).

According to an example embodiment, the first power amplifier (411) and the second power amplifier (412) comprise power amplifiers in which a bias is class-AB. The third power amplifier (421) comprises a power amplifier in which a bias is class-A or class-AB. The fourth power amplifier (422) comprises a power amplifier in which a bias is class-C.

According to an example embodiment, the coupler (440) includes a first port connected to an output end of the first power amplifier (411), a second port connected to an output end of the second power amplifier (412), a third port connected to an input end of the third power amplifier (421), and a fourth port connected to an input end of the fourth power amplifier (422).

According to an example embodiment, the coupler (440) comprises at least one of a coupled line coupler, a lange coupler, a hybrid coupler, or a ring hybrid coupler.

According to an example embodiment, the Doherty power amplifier (400) further comprises a transmission line (430) configured for phase delay. An input end of the third power amplifier (421) is connected to the coupler (440) through the transmission line (430).

According to an example embodiment, the Doherty power amplifier (400) further comprises a combiner (450). The combiner (450) is connected to an output end of the third power amplifier (421), an output end of the fourth power amplifier (422), and the load impedance (460).

According to an example embodiment, the combiner (450) comprises a lumped element, a lumped element and a transmission line, a transmission line, or a lumped element and a transformer.

According to an example embodiment, a magnitude of a first signal input to an input end of the third power amplifier (421) corresponds to a magnitude of a second signal input to an input end of the fourth power amplifier (422).

According to an example embodiment, the Doherty power amplifier (400) further comprises a power splitter (470). The power splitter (470) is connected to an input end of the first power amplifier (411) and an input end of the second power amplifier (412).

According to an example embodiment, based on the Doherty power amplifier (400) being in a first state, an output signal of the first power amplifier (411) is branched through the coupler (440). Based on the Doherty power amplifier (400) being in a second state, the output signal of the first power amplifier (411) is applied to the third power amplifier (421) through the coupler (440) and an output signal of the second power amplifier (412) is applied to the fourth power amplifier (422) through the coupler. The first state is a state in which output power of the Doherty power amplifier (400) is greater than or equal to a threshold value. The second state is a state in which the output power is less than the threshold value.

As described above, according to various example embodiments, an electronic device (910) in wireless communication system, comprises at least one processor (914). The electronic device (910) comprises a plurality of radio frequency, RF, chains (913) connected to the at least one processor (914). The electronic device (910) comprises a plurality of antenna elements (911) connected to the plurality of RF chains (913). A RF chain of the plurality of RF chains (913) includes a Doherty power amplifier (400). The Doherty power amplifier (400) comprises a first stage (410) including a first power amplifier (411) and a second power amplifier (412). The Doherty power amplifier (400) comprises a second stage (420) including a third power amplifier (421) and a fourth power amplifier (422). The Doherty power amplifier (400) comprises a coupler (440) between the first stage (410) and the second stage (420). The Doherty power amplifier (400) comprises a load impedance (460) connected to the second stage (420). A bias of the first power amplifier (411) is different from a bias of the second power amplifier (412). A bias of the third power amplifier (421) corresponds to a bias of the fourth power amplifier (422).

According to an example embodiment, the first power amplifier (411) and the second power amplifier (412) comprise power amplifiers in which a bias is class-AB. The third power amplifier (421) comprises a power amplifier in which a bias is class-A or class-AB. The fourth power amplifier (422) comprises a power amplifier in which a bias is class-C.

According to an example embodiment, the coupler (440) includes a first port connected to an output end of the first power amplifier (411), a second port connected to an output end of the second power amplifier (412), a third port connected to an input end of the third power amplifier (421), and a fourth port connected to an input end of the fourth power amplifier (422).

According to an example embodiment, the coupler (440) comprises at least one of a coupled line coupler, a lange coupler, a hybrid coupler, or a ring hybrid coupler.

According to an example embodiment, the Doherty power amplifier (400) further comprises a transmission line (430) configured for phase delay. An input end of the third power amplifier (421) is connected to the coupler (440) through the transmission line (430).

According to an example embodiment, the Doherty power amplifier (400) further comprises a combiner (450). The combiner (450) is connected to an output end of the third power amplifier (421), an output end of the fourth power amplifier (422), and the load impedance (460).

According to an example embodiment, the combiner (450) comprises a lumped element, a lumped element and a transmission line, a transmission line, or a lumped element and a transformer.

According to an example embodiment, a magnitude of a first signal input to an input end of the third power amplifier (421) corresponds to a magnitude of a second signal input to an input end of the fourth power amplifier (422).

According to an example embodiment, the Doherty power amplifier (400) further comprises a power splitter (470). The power splitter (470) is connected to an input end of the first power amplifier (411) and an input end of the second power amplifier (412).

According to an example embodiment, based on the Doherty power amplifier (400) being in a first state, an output signal of the first power amplifier (411) is branched through the coupler (440). Based on the Doherty power amplifier (400) being in a second state, the output signal of the first power amplifier (411) is applied to the third power amplifier (421) through the coupler (440) and an output signal of the second power amplifier (412) is applied to the fourth power amplifier (422) through the coupler (440). The first state is a state in which output power of the Doherty power amplifier (400) is greater than or equal to a threshold value. The second state is a state in which the output power is less than the threshold value.

Methods according to the various example embodiments described in the claims or the present disclosure may be implemented in the form of hardware, software, or a combination of hardware and software.

When implemented as software, a non-transitory computer-readable storage medium storing one or more program (software module) may be provided. The one or more program stored in the computer-readable storage medium is configured for execution by one or more processor in the electronic device. The one or more program include instructions that cause the electronic device to execute methods according to embodiments described in the present disclosure.

Such program (software modules, software) may be stored in random access memory, non-volatile memory including flash memory, read only memory (ROM), electrically erasable programmable read only memory (EEPROM), magnetic disc storage device, compact disc-ROM (CD-ROM), digital versatile disc (DVD) or other form of optical storage, magnetic cassette. Alternatively, it may be stored in a memory configured with some or all combinations thereof. In addition, each configuration memory may be included a plurality.

In addition, the program may be stored in an attachable storage device that may be accessed through a communication network, such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may access a device performing an embodiment of the present disclosure.

In the above-described example embodiments of the present disclosure, the component included in the disclosure is expressed in singular or plural according to the presented specific embodiment. However, singular or plural expression is chosen appropriately for the situation presented for convenience of explanation, and the present disclosure is not limited to singular or plural component, and even if the component is expressed in plural, it may be configured with singular, or even if it is expressed in singular, it may be configured with plural.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A Doherty power amplifier (400) in wireless communication system, comprising:

   a first stage (410) including a first power amplifier (411) and a second power amplifier (412);
   a second stage (420) including a third power amplifier (421) and a fourth power amplifier (422);
   a coupler (440) between the first stage (410) and the second stage (420); and
   a load impedance (460) connected to the second stage (420),
   wherein a bias of the first power amplifier (411) is different from a bias of the second power amplifier (412), and
   wherein a bias of the third power amplifier (421) corresponds to a bias of the fourth power amplifier (422).

2. The Doherty power amplifier (400) of claim 1,

   wherein the first power amplifier (411) and the second power amplifier (412) comprise power amplifiers in which a bias is class-AB,
   wherein the third power amplifier (421) comprises a power amplifier in which a bias is class-A or class-AB, and
   wherein the fourth power amplifier (422) comprises a power amplifier in which a bias is class-C.

3. The Doherty power amplifier (400) of claim 1,
   wherein the coupler (440) includes a first port connected to an output end of the first power amplifier (411), a second port connected to an output end of the second power amplifier (412), a third port connected to an input end of the third power amplifier (421), and a fourth port connected to an input end of the fourth power amplifier (422).

4. The Doherty power amplifier (400) of claim 1,
   wherein the coupler (440) comprises at least one of a coupled line coupler, a lange coupler, a hybrid coupler, or a ring hybrid coupler.

5. The Doherty power amplifier (400) of claim 1,

   wherein the Doherty power amplifier (400) further comprises a transmission line (430) configured for phase delay,
   wherein an input end of the third power amplifier (421) is connected to the coupler (440) through the transmission line (430).

6. The Doherty power amplifier (400) of claim 1,

   wherein the Doherty power amplifier (400) further comprises a combiner (450),
   wherein the combiner (450) is connected to an output end of the third power amplifier (421), an output end of the fourth power amplifier (422), and the load impedance (460).

7. The Doherty power amplifier (400) of claim 6,
   wherein the combiner (450) comprises at least one of:

   a lumped element,
   a lumped element and a transmission line,
   a transmission line, or
   a lumped element and a transformer.

8. The Doherty power amplifier (400) of claim 1,
   wherein a magnitude of a first signal input to an input end of the third power amplifier (421) corresponds to a magnitude of a second signal input to an input end of the fourth power amplifier (422).

9. The Doherty power amplifier (400) of claim 1,

   wherein the Doherty power amplifier (400) further comprises a power splitter (470),
   wherein the power splitter (470) is connected to an input end of the first power amplifier (411) and an input end of the second power amplifier (412).

10. The Doherty power amplifier (400) of claim 1,

    based on the Doherty power amplifier (400) being in a first state, an output signal of the first power amplifier (411) is branched through the coupler (440),
    based on the Doherty power amplifier (400) being in a second state, the output signal of the first power amplifier (411) is applied to the third power amplifier (421) through the coupler (440) and an output signal of the second power amplifier (412) is applied to the fourth power amplifier (422) through the coupler,
    wherein the first state is a state in which output power of the Doherty power amplifier (400) is greater than or equal to a threshold value,
    wherein the second state is a state in which the output power of the Doherty power amplifier is less than the threshold value.

11. An electronic device (910) in wireless communication system, comprising:

    at least one processor (914);
    a plurality of radio frequency, RF, chains (913) connected to the at least one processor (914); and
    a plurality of antenna elements (911) connected to the plurality of RF chains (913),
    wherein an RF chain of the plurality of RF chains (913) includes a Doherty power amplifier (400),
    wherein the Doherty power amplifier (400) comprises:

    a first stage (410) including a first power amplifier (411) and a second power amplifier (412);
    a second stage (420) including a third power amplifier (421) and a fourth power amplifier (422);
    a coupler (440) between the first stage (410) and the second stage (420); and
    a load impedance (460) connected to the second stage (420),

    wherein a bias of the first power amplifier (411) is different from a bias of the second power amplifier (412), and
    wherein a bias of the third power amplifier (421) corresponds to a bias of the fourth power amplifier (422).

12. The electronic device (910) of claim 11,

    wherein the first power amplifier (411) and the second power amplifier (412) comprise power amplifiers in which a bias is class-AB,
    wherein the third power amplifier (421) comprises a power amplifier in which a bias is class-A or class-AB, and
    wherein the fourth power amplifier (422) comprises a power amplifier in which a bias is class-C.

13. The electronic device (910) of claim 11,
    wherein the coupler (440) includes a first port connected to an output end of the first power amplifier (411), a second port connected to an output end of the second power amplifier (412), a third port connected to an input end of the third power amplifier (421), and a fourth port connected to an input end of the fourth power amplifier (422).

**14.** The electronic device (910) of claim 11,
wherein the coupler (440) comprises at least one of a coupled line coupler, a lange coupler, a hybrid coupler, or a ring hybrid coupler.

**15.** The electronic device (910) of claim 11,

wherein the Doherty power amplifier (400) further comprises a transmission line (430) configured for phase delay, wherein an input end of the third power amplifier (421) is connected to the coupler (440) through the transmission line (430).

FIG. 1

200

Input   Transistor            Output

$Z_{in}$   +   $I_D$

201

202

FIG. 2A

210

220 240 230 231 251

Driver Stage 221 Main Stage

Signal1 Signal3

Amplifier (Q1) Phase Delay ($\theta_D$) Amplifier (Q3) $R_0 \angle 90°$

Input Signal
Power splitter $I_0 \angle \theta_a$ 260

$\theta_b - \theta_a = \Delta\theta$ $R_L$

270 $I_0 \angle \theta_b$ 252

Amplifier (Q2) Amplifier (Q4) $R_0 \angle 180°$

Signal1 Signal1

222 232

FIG. 2B

FIG. 3A

FIG. 3B

FIG. 3C

400

410                    440    430              420    421

411                                                              Signal3
                                                                          → 450
Input                I₁ ∠ θ₁    I₃ ∠ θ₃    Signal1
Signal                                                              Z₁
                Driver Stage                        Main Stage

        Amplifier                    Phase    Amplifier
        (Q1)            1      2      Delay    (Q3)                        460
Input                                (θ_D)                     a
Signal   Power                                        I₀ ∠ θₐ  Load
    ○──  splitter              Coupler              θ_b - θₐ = Δθ  modulation  c
                                                              combiner  ─ R_L
        Amplifier       4      3              Amplifier  I₀ ∠ θ_b       b
        (Q2)                                  (Q4)

470     I₂ ∠ θ₂    I₄ ∠ θ₄    Signal2                  Z₂    Signal4
                                                                  →

        412                                    422

FIG. 4

510

520

530

540

FIG. 5

Coupled Line Coupler

610

Lange Coupler

620

Hybrid Coupler

630

Ring Hybrid Coupler

640

FIG. 6

FIG. 7

FIG. 8A

FIG. 8B

FIG. 8C

FIG. 8D

FIG. 9

## INTERNATIONAL SEARCH REPORT

| International application No. |
|---|
| **PCT/KR2023/008701** |

**A. CLASSIFICATION OF SUBJECT MATTER**

**H03F 1/02**(2006.01)i; **H03F 3/21**(2006.01)i; **H03F 1/56**(2006.01)i

According to International Patent Classification (IPC) or to both national classification and IPC

**B. FIELDS SEARCHED**

Minimum documentation searched (classification system followed by classification symbols)

H03F 1/02(2006.01); G01R 19/00(2006.01); H03F 1/07(2006.01); H03F 3/19(2006.01); H03F 3/21(2006.01); H03F 3/60(2006.01); H03F 3/68(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 도허티(doherty), 전력 증폭기(power amplifier), 스테이지(stage), 커플러 (coupler), 안테나(antenna), 바이어스(bias)

**C. DOCUMENTS CONSIDERED TO BE RELEVANT**

| Category* | Citation of document, with indication, where appropriate, of the relevant passages | Relevant to claim No. |
|---|---|---|
| A | KR 10-1704541 B1 (KWANGWOON UNIVERSITY INDUSTRY-ACADEMIC COLLABORATION FOUNDATION) 23 February 2017 (2017-02-23)<br>See paragraphs [0057]-[0078] and figure 5. | 1-15 |
| A | US 2016-0006401 A1 (INTEL CORPORATION) 07 January 2016 (2016-01-07)<br>See paragraphs [0028]-[0036], claim 22 and figure 5. | 1-15 |
| A | KR 10-2022-0073496 A (SAMSUNG ELECTRONICS CO., LTD.) 03 June 2022 (2022-06-03)<br>See paragraphs [0042], [0046] and [0136]-[0142] and figure 8. | 1-15 |
| A | KR 10-1066640 B1 (PEOPLEWORKS CO., LTD.) 22 September 2011 (2011-09-22)<br>See paragraphs [0032] and [0033]. | 1-15 |
| A | US 2021-0305942 A1 (QORVO US, INC.) 30 September 2021 (2021-09-30)<br>See paragraph [0026]. | 1-15 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **16 October 2023** | **16 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| KR | 10-1704541 | B1 | 23 February 2017 | KR | 10-2015-0136735 | A | 08 December 2015 |
| US | 2016-0006401 | A1 | 07 January 2016 | US | 2012-0231753 | A1 | 13 September 2012 |
| | | | | US | 9083284 | B2 | 14 July 2015 |
| | | | | US | 9614480 | B2 | 04 April 2017 |
| KR | 10-2022-0073496 | A | 03 June 2022 | CN | 116635727 | A | 22 August 2023 |
| | | | | EP | 4231024 | A1 | 23 August 2023 |
| | | | | WO | 2022-114855 | A1 | 02 June 2022 |
| KR | 10-1066640 | B1 | 22 September 2011 | KR | 10-2011-0037033 | A | 13 April 2011 |
| US | 2021-0305942 | A1 | 30 September 2021 | US | 10978999 | B2 | 13 April 2021 |
| | | | | US | 11699978 | B2 | 11 July 2023 |
| | | | | US | 2019-0379335 | A1 | 12 December 2019 |

Form PCT/ISA/210 (patent family annex) (July 2022)